Europäisches Patentamt

European Patent Office

Office européen des brevets

(11) Publication number: **0 223 830 B1**

## EUROPEAN PATENT SPECIFICATION

(45) Date of publication of patent specification: **01.07.92** (51) Int. Cl.5: **H01R 4/02**, H01R 11/22

(21) Application number: **86903845.5**

(22) Date of filing: **15.05.86**

(86) International application number:
**PCT/US86/01080**

(87) International publication number:
**WO 86/07198 (04.12.86 86/26)**

(54) **SOLDER-BEARING LEADS.**

(30) Priority: **24.05.85 US 737830**
**31.10.85 US 793654**
**11.04.86 US 850754**

(43) Date of publication of application:
**03.06.87 Bulletin 87/23**

(45) Publication of the grant of the patent:
**01.07.92 Bulletin 92/27**

(84) Designated Contracting States:
**AT BE CH DE FR GB IT LI LU NL SE**

(56) References cited:
**EP-A- 0 088 582     DE-A- 2 231 828**
**US-A- 4 423 920     US-A- 4 439 000**
**US-A- 4 482 197     US-A- 4 500 149**
**US-A- 4 502 745     US-A- 4 503 609**
**US-A- 4 537 461     US-A- 4 541 034**

(73) Proprietor: **NORTH AMERICAN SPECIALTIES CORP.**
**120-12 28th Avenue**
**Flushing, NY 11354(US)**

(72) Inventor: **SEIDLER, Jack**
**120-12 28th Avenue**
**Flushing, NY 11354(US)**

(74) Representative: **Patentanwälte Grünecker, Kinkeldey, Stockmair & Partner**
**Maximilianstrasse 58**
**W-8000 München 22(DE)**

Rank Xerox (UK) Business Services

## Description

The invention relates to a solder-bearing lead according to the preamble of claim 1, and to a method of its manufacturing in accordance with the preamble of claim 22.

A solder-bearing lead and a method of this type are disclosed in EP-A-0 088 582. The known solder-bearing lead is used as a press-fit pin to be pressed into bores of a substrate containing a conductive surface. The pin is stamped from a sheet metal. Thereafter, the press-fit zone is provided with a solder-bearing recess by use of coacting dies. The press-fit zone is shaped into a H-shaped cross-sectional area with recesses adapted to receive the solder mass in a direction longitudinally to the pin. This arrangement, however, is effective only for press-fit pins which are to be secured within a bore.

For soldering strip-like body portions to a conductive surface, arrangements as shown in US-A-4 482 197 have been used. The solder mass of the known leads is held by a finger cut from the strip-like body portions by two cuts beginning at one end of the strip and extending longitudinally into the strip. The finger has been bent out of the plane of the strip in the longitudinal direction. With such an arrangement, however, only the ends of the body portion can be secured to the conductive surface. In addition, the finger will require a predetermined width of the strip in order to ensure that an appropriate holding force can be applied to the solder mass while maintaining a proper mechanical strength of the remaining part of the lead.

Therefore there remains a need for a solder-bearing lead which is easy to manufacture, and which can attach at a predetermined location of its length to the conductive surface without being weakened by the solder holding means.

A solder-bearing lead and a method of its manufacturing fulfilling this need are disclosed in claims 1 and 22.

The solder-bearing lead of the present invention is particularly useful with multiple-contact connectors and electronic circuit boards, and for surface-mounted devices. The lead of the present invention is suitable for being continuously stamped from a strip of metal at high speed, with an improved arrangement for securely holding the solder mass to provide the necessary solder for a soldered joint, without weakening the lead. Instead of retaining the solder mass by means of a finger struck from the elongated body of the lead (which for narrow leads might only weakly retain the solder and also weaken the lead by unduly reducing its already small cross-section), the solder mass is retained by tabs or ears initially extending laterally from the elongated blank body, and then bent to form a solder-retaining channel. This provides a secure mechanical attachment for the solder mass to the lead, to provide each lead with the necessary supply of solder at a proper location for its attachment to and electrical bonding to another conductive surface.

This is particularly desirable for surface-mounted devices on printed circuit boards or other substrates. In addition, this arrangement can be made by automatic progressive stamping by simple and efficient steps, at high speed.

Further developments of the inventive product and the inventive method are described in the subclaims.

Brief Description of the Drawings

With particular reference to the drawings, several forms of the invention are shown in the various figures, where like reference characters designate like parts throughout the several views. In the drawings,

Fig. 1 shows a plan view of a strip formed into flat blanks for use in making one embodiment of the improved lead of the invention;

Fig. 2 is a plan view of one of the leads made from the blank of Fig. 1, formed to hold a solder mass;

Fig. 3 is a sectional elevation view of the arrangement of Fig. 2, showing the solder mass positioned between retaining tabs;

Fig. 4 shows the arrangement of Fig. 3 with the retaining tabs staked into the solder mass;

Fig. 4A shows an alternative arrangement to that of Fig. 4.

Fig. 5 shows a side sectional elevational view of an edge clip solderable connector for a printed circuit board or the like, made from the blank of Fig. 1;

Fig. 6 shows a plan view of a modified form of the stamped blank for another embodiment of the invention;

Fig. 7 shows a side elevation view of an edge clip for a printed circuit board, which may be formed from the blank of Fig. 6, and is adapted for surface mounting on a substrate;

Fig. 8 shows a side elevation view of a partially formed blank for the embodiment of Figs. 6 and 7;

Fig. 9 shows a transverse elevation sectional view of a vertically mounted pin-receiving connector adapted for surface mounting on a substrate by use of the solderable lead of the present invention;

Fig. 10 is a transverse elevation sectional view of another connector for a vertically mounted printed circuit board, adapted to be mounted on a substrate by use of the solderable lead of the present invention; and

Fig. 11 shows a plan view of an alternate form of strip of blanks useful in connection with the previous embodiments of the present invention for economy of material and providing closer spacing of the leads;

Fig. 12 shows a side elevational view of a connector arrangement according to the invention for joining two printed circuit boards or the like in coplanar alignment;

Fig. 13 shows a plan view of a modified form of stamped blank for another embodiment of the invention;

Fig. 14 shows a side elevation view, partly in cross-section, of a clip for a circuit board or the like, made from the blank of Fig. 13, and adapted for surface mounting the circuit board on a substrate;

Fig. 15 shows a plan view of still another embodiment of a stamped blank constituting a form of the invention;

Fig. 16 is a side elevation view, partly in section, of another embodiment of a device similar to Fig. 14, showing a different form of solderable surface mounting;

Fig. 17 is a fragmentary plan view of a modification of the invention having a single pair of ears for retaining the solder mass;

Fig. 18 is a perspective view of another form of terminal connector according to the invention;

Fig. 19 is a fragmentary plan view of a further modification of the invention having a single tab on either side of the body for retaining the solder mass;

Fig. 20 is a side view of the embodiment of Figure 19, when assembled with a solder mass;

Fig. 21 is a front view of the arrangement of Fig. 20;

Fig. 22 shows a side view of a circuit component having terminals as shown in Figs. 19 to 21, and adapted for surface mounting on a substrate.

Description of Preferred Embodiments

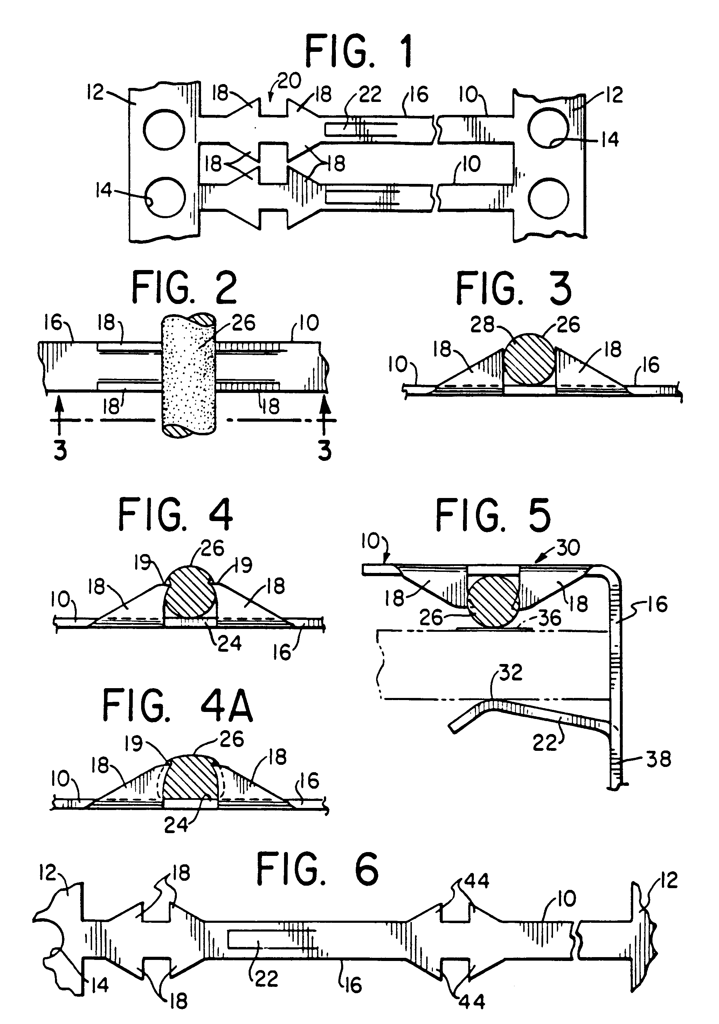

Referring to the drawings, Fig. 1 illustrates a stamped strip having a sequence of individual blanks 10 for the leads of the invention, formed by stamping from a conductive strip (as of beryllium copper or like resilient and conductive material), with the individual lead blanks 10 extending between a pair of carrier strips 12. Strips 12 may carry sprocket holes 14 for indexing the lead blanks step-by-step through subsequent progressive stamping steps for forming the blanks into final form.

Each lead is formed of an elongated body section 16 of length appropriate for the intended use of the finished lead, and having oppositely extending tabs 18 on its lateral edges, in the form of sloping extensions with a gap 20 therebetween. The gap 20 is dimensioned to have a width substantially equal to the width of a solder wire to be laid therein, and a depth dimension somewhat less than the solder wire dimension, as will be seen. In addition, the body section 16 is slitted or cut to form a resilient. finger 22. It will be understood that the tabs are not necessarily triangular in shape but may be rectangular or of other shape, preferably with straight edges extending transversely of the lead body.

For holding a solder mass or slug to the lead, in the forming process, the tabs 18 are bent out of the plane of the body section 16 into a position substantially perpendicularly, as shown in Figs. 2 and 3, thereby providing a channel 24 having a "floor" formed by the body section 16, and sides formed by the edges of the tabs 18. Into this channel is laid solder, preferably as a wire 26, which may extend across the successive blanks. The wire 26 may be cut on either side of the lead body 16 an appropriate distance from the tabs 18 to supply the desired amount of solder for the soldering operation. The solder wire 26 preferably closely conforms to the width of the channel 24, and may be flush with or extend somewhat above the channel 24, as seen in Fig. 3, so that the solder has an exposed surface 28. After the solder wire is positioned within channel 24, and either before or after it is cut into the appropriate section lengths, the tabs 18 may be bent inwardly to stake the solder mass 26 in place and thereby retain it physically connected to the body section 16, as shown in Fig. 4. Thus, each terminal blank will have a solder slug held by it at the proper position for most effective soldering operations.

Fig. 4A shows an alternative configuration to that of Fig. 4, where the solder mass 26 is pushed into the channel 24 to nearly fill the channel, and to offer a lower profile so that on juxtaposition to the element to which the lead is to be soldered, the tabs 18 will be closer to that element, to improve the reliability of soldering. The exposed surface 28 may have the solder mass flush with the tabs 18, or even slightly recessed into channel 24, as desired, so as to permit even closer contact, before soldering, between the retaining tabs and the corresponding element to which they are to be soldered.

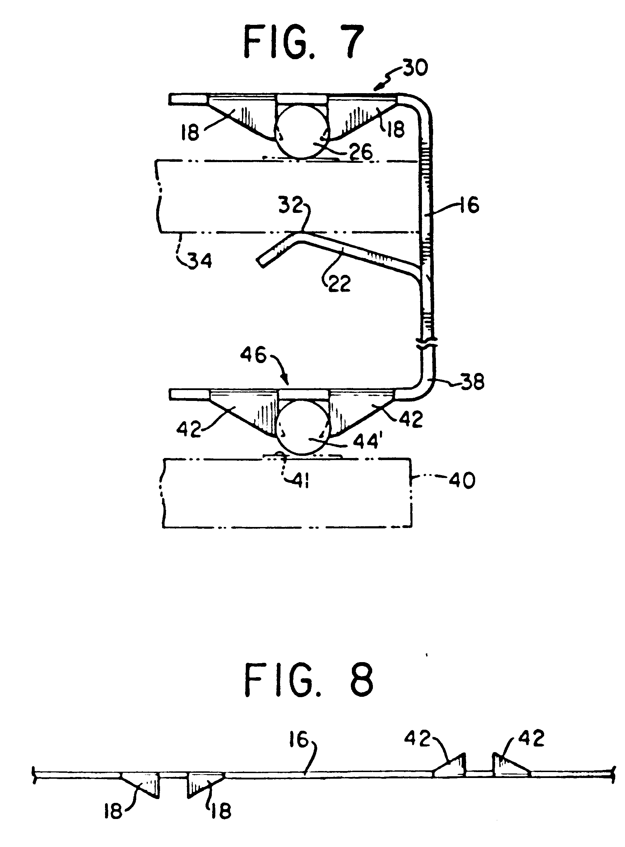

With the solder mass projecting very slightly outwardly of the retaining tabs, upon insertion of the circuit board to be soldered into the gap between a pair of solder masses (or between one solder mass and a resilient opposed member as in Fig. 7), the insertion of the circuit board will serve to wipe off excess solder (which is relatively soft) and smear it over the adjacent portion of the contact pad, which will assist in obtaining a good solder joint.

It will be understood that this solder-retaining arrangement, depicted in Figs. 2 to 4 and 4A, may be used in various applications in the electronics art, some of which are described below.

In one use, the blank 10 of Fig. 1 may be formed with a resilient finger 22. As seen in Fig. 5, the solder-bearing portion 30 of the lead is bent substantially at a right angle to the remainder of the body portion 16 and the spring finger 22 is positioned with a bend 32 opposite the solder mass 26. This provides a springy gap between the solder 26 and the bend 32 within which may be inserted a circuit board or other substrate 34, having a conductive area or contact pad 36 to which it is desired to solder the lead. The resilience of finger 22 serves to retain the lead in position on the circuit board 34 before the soldering is done, and as the solder melts upon application of heat, the finger 22 serves to allow the tabs 18 to move relatively toward and into contact with the conductive area 36, to provide good electrical contact between the lead and the conductive area 36 when the solder re-solidifies. In this application, the lead forms an edge clip for the circuit board 34, and the terminal end 38 of the lead may be suitably formed in a number of ways for connection to other equipment, such as being formed as a pin for insertion into a contact receptacle, or as a wire-wrap post termination, or as a further solderable arrangement, indicated below.

Fig. 6 shows a modified form of strip blank carrying a lead blank as a modification of Fig. 1. In this form each lead blank is provided with a second set of solder-retaining tabs 44. As shown in Fig. 7, the terminal portion 38 of the lead is formed with a solder-retaining arrangement 46 essentially the same as arrangement 30 of Fig. 5. However, in this instance, tabs 42 are bent from the body portion 16 in a direction opposite to that of the tabs 18, as shown in Fig. 8, so that the terminal solder-retaining arrangement 46 may be used for surface mounting the circuit board 34 on a further substrate 40 for connection to a conductive area 41 on substrate 40.

In an alternate form (not illustrated), the tabs 44 may be bent in the same direction as tabs 18, in which case the terminal portion 38 of the lead, instead of extending to the left as seen in Fig. 7, would extend to the right.

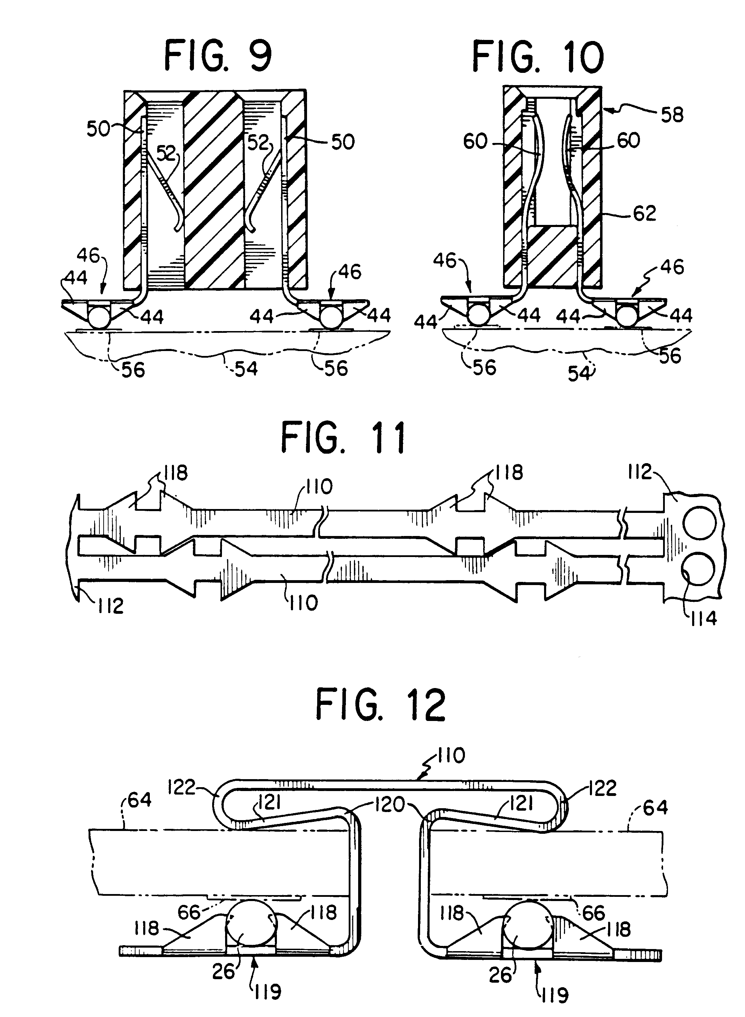

The solder-retaining arrangement of the present invention may also be used as a terminal portion of other forms of leads, terminals, contacts, and connectors. Thus, as seen in Fig. 9, the solder-retaining arrangement 46 may be the terminal for a contact 50 of a multiple-contact connector where each contact 50 is in a channel 48 into which extends a spring finger 52 integrally formed with the contact 50, for mating contact with a pin when inserted into channel 48. Fig. 9 illustrates a cross-section of a dual row of pin-receiving receptacles, each formed as shown in Fig. 9. It will be understood that the same arrangement may be used for single-row or other multiple-row connectors, permitting surface mounting upon a substrate having conductive areas 56 to which the contacts 50 are to be soldered. While the channels 48 are shown in this instance as perpendicular to the substrate 54, suitable for a vertically oriented connector, other arrangements may be made by which the connector may be oriented horizontally or at other angles.

Fig. 10 illustrates use of the solder-retaining terminal arrangement 46 for surface mounting a circuit board connector 58 on a substrate 54. This figure shows a transverse cross-section of a multiple-contact circuit board edge-connector having a housing 62 in which are mounted spring contacts 60 for separable connection to contact pads on the circuit board when inserted. It will be obvious how the blanks for forming the leads and contacts of Figs. 9 and 10 are formed. In each case, there will be tabs such as 44 or 18 bent outwardly from the body of the lead, the remainder of the lead being suitably formed for its intended purpose as in Figs. 5, 7, 9 or 10.

As shown in Fig. 1, the blanks 10 formed into the multiple blank strip are generally side-by-side and in alignment. However, in some instances it may be desirable to place them closer together, as for automatic insertion into housings having closely-spaced channels, or for purposes of economizing on waste material. Fig. 11 shows how the blank leads 110 may be staggered on the carrier strip to place them more closely for this purpose.

Fig. 12 shows a form of the invention adapted for joining two printed circuit boards or substrates 64 in co-planar alignment. In this instance, the terminal body 110 is formed at each end with a solder-bearing and holding arrangement 119 formed by ears or tabs 118 similar to tabs 18 of Fig. 4. Each of these solder-holding arrangements 119 is adapted for soldering to a contact pad 66 of a respective substrate or printed circuit board 64. The contact body 110 joining the two solder-bearing portions 119 is bent at 120 and 122 to form two resilient portions 121, each cooperating with a solder-holding portions 119 to retain a substrate 64 therebetween during the soldering operation.

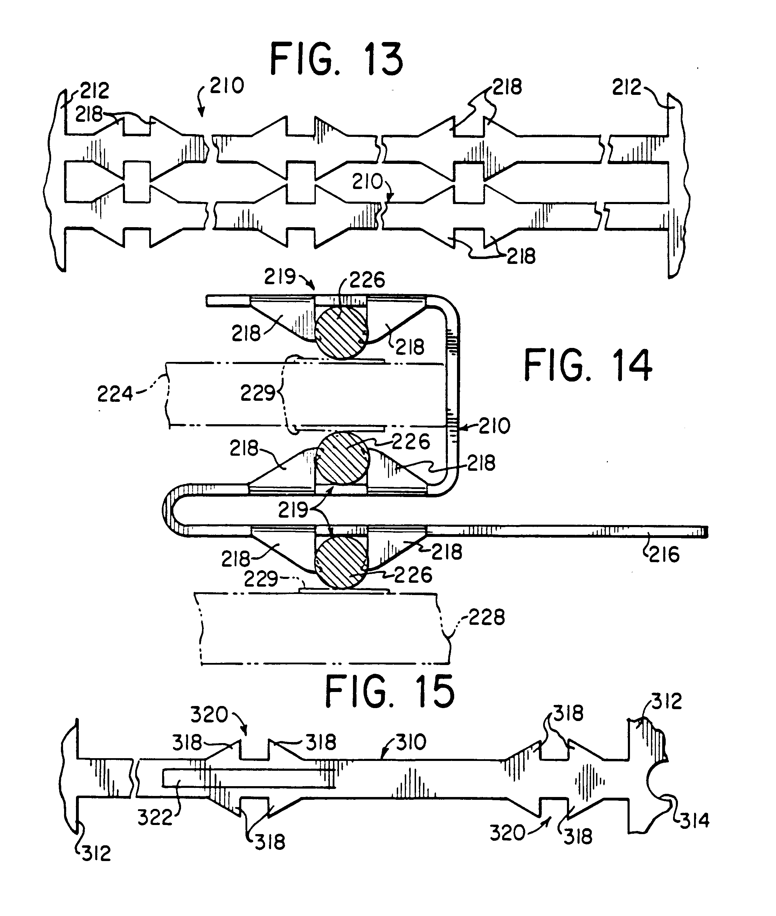

Fig. 13 shows another form of blank usable in another embodiment of the invention. In this instance, the terminal body 210 extending between the carrier strips 212 has three sets of ears or tabs 218 for the purpose of retaining three solder masses. This blank of Fig. 13 may be bent in the form of Fig. 14, so that two of the solder-retaining arrangements 219 straddle the substrate 224 for soldering to contact pads 226 thereon. The third solder-bearing arrangement 219' is adapted for surface mounting the substrate 226 and its connected terminal 210 to an additional substrate 228 having a contact pad 229 thereon, in evident manner.

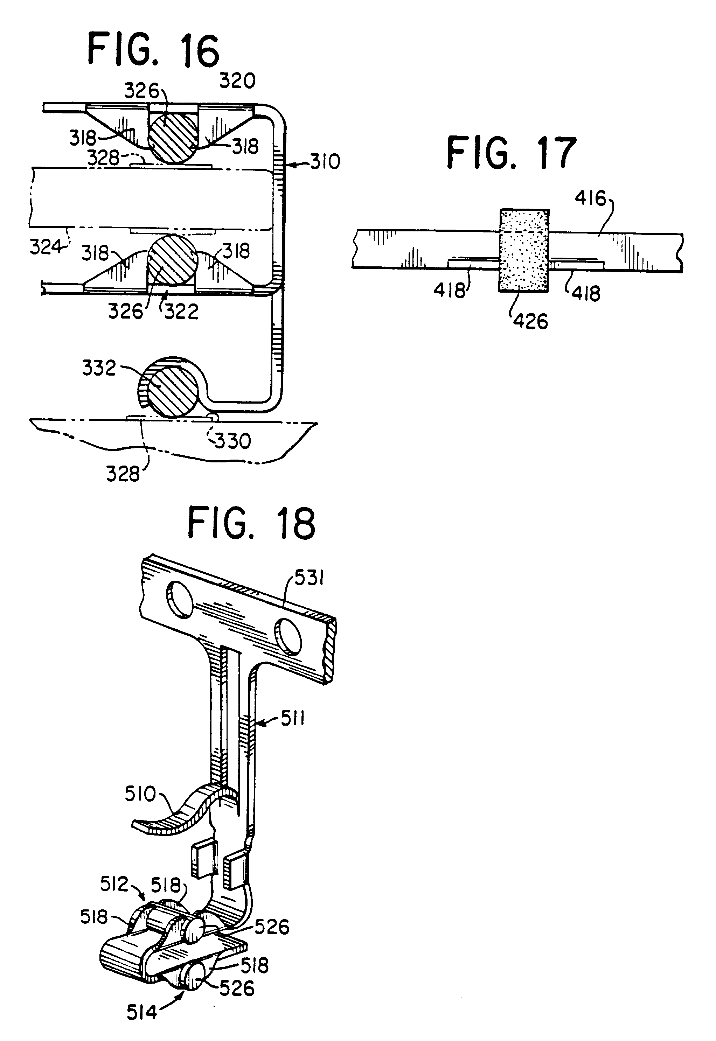

Fig. 15 shows still another blank having two solder-holding arrangements 320 and 322 formed by solder-retaining tabs 318. In addition, a spring finger 322 may be cut or punched out from the center of the terminal body 310. As shown in Fig. 16, the solder-retaining arrangements 320 and 322, similar to those disclosed above, are adapted for soldering to the respective contact pads 326 of a substrate 324. The finger 322 may be used for surface mounting the entire arrangement on an additional substrate 328, having a contact pad 330, by being wrapped around a solder mass 332 by at least 180° to retain the solder mass 332 between the pad 330 and the terminal 322, pending the soldering operation.

While in each of the foregoing arrangements the solder mass exemplified by 26 or 126 or the like has been shown as held by two sets of ears or tabs 218, one set being bent up from each edge of the main lead body, it will be understood that at some instances a single pair of tabs 418 may be used as shown in Fig. 17. This will have the advantage of permitting use of a narrower blank 416 with a saving of material, where satisfactory retention of the solder slug 426 is obtainable.

Fig. 18 shows a perspective view of a special contact 511 to connect a substrate to a second substrate by surface mounting. The contact 511 is carried on a carrier strip 531, which may be cut away (together with any unneeded section of the contact body) upon or prior to attachment of contact 511 with a substrate. In this structure, a spring finger 510 cooperates with a solder-bearing arrangement 512 of any of the types indicated above, to form a gap therebetween to receive a substrate which carries contact pads. A lower contact pad on such substrate may be soldered to the contact 511 by means of the solder arrangement 512 while the upper spring finger 510 serves to clamp the solder-holding arrangement 512 in position during the soldering operation. This spring finger 510 may also be used to connect a contact pad or circuit portion on the upper side of the substrate to the contact 511 and to the lower contact pad to which it is soldered by the solder arrangement 512.

A second solder arrangement 514 is supplied, which may be of any of the types described above, and permits the entire arrangement of substrate and terminal to be surface mounted and soldered to an additional substrate, generally as shown in Figs. 14 and 16.

Fig. 18 also shows a modified arrangement for holding the solder slug 526 between the ears 518 in a fashion where the solder 526 is essentially flush with the edge of the tabs 518, to facilitate contact between the tabs 518 and the contact pad to which it is to be soldered. It will be understood that this arrangement also may be used in place of those shown in Figs. 4 and 4A.

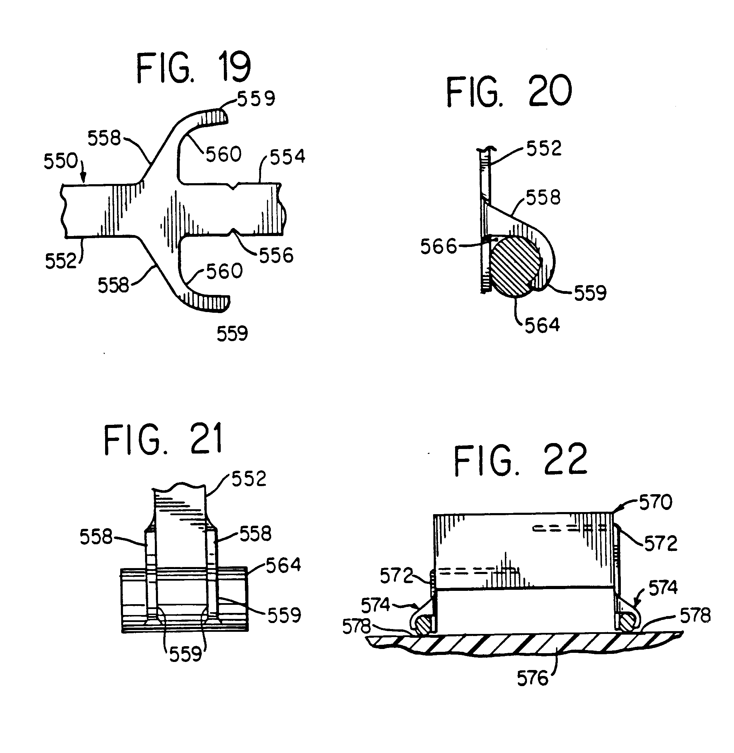

Figs. 19-21 show another form of device according to the invention, particularly adapted for a terminal for surface mounting a circuit component or lead to a substrate. Figure 19 shows a blank for such a lead.

In this form, the solder mass may be retained by a single tab or finger, at one or both edges of the main body of the terminal, and bent to a perpendicular position relative to the terminal body. Lead 550 has a flat elongated body portion 552 adapted to be connected to the usual carrier strip by a section 554 having a frangible portion 556. Formed on the lead on either side of the main body portion 552 is a pair of tabs 558 having curved fingers 559. As indicated in Figs. 20 and 21, the tabs 558 are bent into a position perpendicular to the plane of the main body 552 to form a channel 566, one face of which is formed by the lead body 552 and the opposite side of which is defined by the inner edges of the tab fingers 559. In manufacture, a solder mass 564 (which may be a short section of solder wire), is interposed in the channel 566, and the finger-like extremities 559 of tabs 558 are bent around the solder mass 564, with the ends 559 indented or staked into the solder mass 564 so as to retain it in the channel 566, in a position such that the solder extends flush with or slightly below the extremities of the body 552 and of the fingers 559. In some instances, a single tab 558 may suffice.

The opposite end of the lead 552 (not shown) may be of any suitable formation, for connecting to other electrical apparatus. For example, it may be a wire-wrap post, or a spring or pin contact of a connector, or merely a terminal to which other electrical components may be connected or soldered. Figure 22 schematically illustrates a circuit component or device 570 having terminals 572 as body portions connected to circuit elements within device 570 in any suitable manner. The terminals 572 then have terminations 574 as shown in Figs. 20 and 21.

The circuit component 570 with its terminals 572 may then be placed upon a substrate 576 having electrical conducting areas or pads 578 upon each of which a terminal as in Fig. 20 is placed with the solder 564 in contact with the conducting surface 578. It will be understood that thereafter, by appropriately applying heat, the solder 564 is melted, and upon solidification forms a reliable electrical and mechanical joint between the lead body 552 and the tabs 558.

It will be understood that the solder-retaining arrangement of the present invention is suitable for many other applications, where it will have the advantages discussed above as well as others. Accordingly, the above embodiments are to be deemed illustrative only and the present invention is defined by the appended claims.

**Claims**

1. A solder-bearing lead (10,50,60,511,550) adapted to be soldered to a conductive surface (36,41,56,66,229,578), comprising an elongate body portion (16,110,210,310,416,552,572) including means (18,42,44,118,218,318,418,518,558,559,574) for holding a solder mass (26,44',226,326,426,526,564) on said body portion,
   **characterized by** a strip-like body portion (16,110,210,310,416,552,572) having on at least one edge thereof at least one laterally extending tab (18,42,44,118,218,318,418,518,558,559,574) each said tab being bent into a plane substantially perpendicular to the plane of said body portion for holding said solder mass substantially transversely of said body portion.

2. A solder-bearing lead as in claim 1, **wherein** said body portion (16,110,210,310,552,572) is planar and integral with said tab (18,42,44,118,218,318,418,518,558,559,574).

3. A solder-bearing lead as in claim 1 or 2, **wherein** said body portion (16,110,210,310,416) has on at least one edge thereof a pair of spaced laterally extending tabs (18,42,44,118,218,318,418,518) defining an opening (20) therebetween.

4. A lead as in claim 3, **wherein** said opening (20) and said body portion form a channel to receive said solder mass.

5. A solder-bearing lead as in any one of claims 1 to 4 characterised in that said body portion (16,110,210,310) had on each edge a pair of spaced tabs (18,42,44,118,218,318) with an opening therebetween, said opening being aligned transversely of said body to form a channel (24,48,320,322).

6. A solder-bearing lead as in claim 1 or claim 2 **wherein** said body portion (552,572) and the end of said tab (559,574) are substantially coextensive in the direction of said body portion.

7. A solder-bearing lead as in any one of claims 1 to 6, **wherein** each of said tabs (18,42,44,118,218,318,418,518,558,559,574) is bent longitudinally of said body portion (16,110,210,310,416,552,572) for retaining of said solder mass (26,44',226,326,426,526,564).

8. A solder-bearing lead as in any one of claims 4 to 7, **wherein** said tabs (18,42,44,118,218,318,418,518,558,559,574) are bent inwardly of said channel (24,48,320,322,566) and staked into said solder mass.

9. A solder-bearing lead as in any one of claims 1, 2 or 6 **wherein** said tabs (558,559,574) are two in number, each in the form of a finger, one on each edge of said planar body portion (552,572), and said tab fingers curve longitudinally along said body portion.

10. A solder-bearing lead as in claim 9, for surface soldering to a conductive surface, **wherein** each said tab finger (558,559,574) and an end of said body portion form a channel (566) therebetween.

11. A solder-bearing lead as in claim 9 or 10, **wherein** the ends of said tab fingers (558,559,574) partly encircle said solder means (564).

12. A solder-bearing lead as in any one of claims 9 to 11, **wherein** the ends of said tab fingers (558,559,574) are staked into said solder mass (564).

13. A solder-bearing lead as in any one of claims 1 to 12, **wherein** said solder mass (26,44',226,326,426,526,564) is held by said tabs (18,42,44,118,218,318,418,518,558,559,574) transversely of said at least one edge of said body portion (16,110,210,310,416,552,572) from which said tabs extend.

14. A solder-bearing lead as in any one of claims 1 to 13, **wherein** said solder mass (26,44',226,326,426,526,564) extends beyond said at least one edge of said body portion (16,110,210,310,416,552,572) from which said at least one tab (18,42,44,118,218,318,418,518,558,559,574) extends.

15. A solder-bearing lead as in any one of claims 1 to 14, **wherein** said solder mass (26,44',226,326,426,526,564) extends outwardly from said channel (24,48,320,322,566).

16. A solder-bearing lead as in any one of claims 1 to 14, **wherein** the dimension of said solder mass is substantially equal to the projection of said tabs (18,42,44,118,218,318,418,518,558,559,574) away from said body portion.

17. A solder-bearing lead as in any one of claims 1 to 16, **wherein** one end of said lead (10,50,60,110,511,550) is formed as an electrical element.

18. A solder-bearing lead as in any one of claims 1 to 17, **wherein** said lead comprises a circuit board clip.

19. A solder-bearing lead as in any one of claims 1 to 17, **wherein** said lead comprises a pin-receiving connector contact.

20. A solder-bearing lead as in any one of claims 1 to 17, **wherein** said lead comprises a circuit board connector contact.

21. A solder-bearing lead as in any one of claims 1 to 20, further including a spring finger (22,52,322,510) integral with said lead body portion (16,110,210,310,552,572) and positioned opposite to said solder mass (26,44',26,326,426,526,564) to form a clip arrangement for a circuit board or the like.

22. A method of forming a solder-bearing lead (10,50,60,511,550) adapted to be soldered to a conductive surface (36,41,56,66,229,578), **characterized by** the steps of:

forming a flat elongated strip-like blank with a body portion (16,110,210,310,416,552,572), said blank having at least a pair of tabs (18,42,44,118,218,318,418,518,558,559,574), said tabs extending laterally from said body portion with at least one tab of each pair being arranged on one edge thereof, bending each of said tabs on said edge of said body portion substantially perpendicularly of said body portion, placing a solder mass (26,44',226,326,426,526) on said body portion, and staking the edges of said pair of tabs longitudinally of said body portion and into said solder mass to secure said solder mass to said body portion.

23. A method as in claim 22, including the step of forming of a pair of spaced tabs (18,42,44,118,218,318,418,518) with an opening (20) therebetween along one edge of said blank.

24. A method as in claim 23, further including the steps of forming on another edge of said blank a second pair of laterally extending spaced tabs (18,42,44,118,218,318,418,518) with a second opening aligned with said prior opening transversely of said body portion (16,110,210,310), bending said second pair of tabs substantially perpendicularly of said body portion to form a channel (24,48,320,322) having sides formed by said two pairs of spaced tabs and a floor formed by said body portion, placing said solder mass (26,44',226,326,526) in said channel, and staking said edges of said second pair of tabs longitudinally of said body portion with said solder mass.

25. The method as in claim 24, **wherein** said solder mass (26,44',226,326,526) extends outwardly of said channel (24,48,320,322) beyond the tips of said tabs (18,42,44,118,218,318,518).

26. The method as in any one of claims 22 to 25, **wherein** said solder mass (26,44',226,326,526) extends into the opening between said tabs (18,42,44,118,218,318,518) on each edge of said body portion (16,110,210,310).

27. The method as in any one of claims 22 to 24, **wherein** said solder mass (26,44',226,326,426,526) is substantially level with the tips of said tabs (18,42,44,118,218,318,418,518).

28. The method as in any one of claims 22 to 24, **wherein** said solder mass (26,44',226,326,426,526,564) is depressed below the tips of said tabs (18,42,44,118,218,318,418,518,558,559,574).

29. A terminal for a lead for surface mounting on a substrate having a conductive area (36,41,56,66,229,578) comprising a solder-bearing lead as in any one of claims 1 to 21, where said tabs (18,42,118,218,318,418,518,558,559,574) are located adjacent one end of said lead (10,50,60,511,550).

## Revendications

1. Conducteur portant de la soudure (10, 50, 60, 511, 550) afin d'être soudé sur une surface conductrice (36, 41, 56, 66, 229, 550), comprenant une portion de corps allongée (16. 110, 210, 310, 416, 552, 572) comportant des moyens (18, 42, 44, 118, 218, 318, 418, 518, 558, 559, 574) pour supporter une masse de soudure (26, 44', 226, 326, 426,526, 564) sur cette portion de corps, caractérisé par une portion de corps en forme de bande (16, 110, 210, 310, 416, 552, 572) présentant au moins sur l'un de ses bords au moins une languette s'étendant latéralement (18, 42, 44, 118, 218, 318, 418, 518, 558, 559, 574) chacune de ces dernières étant recourbée selon un plan pratiquement perpendiculaire au plan de cette portion de corps pour supporter cette masse de soudure de façon essentiellement transversale à cette portion de corps.

2. Conducteur portant de la soudure selon la revendication 1, dans lequel la portion de corps (16, 110, 210, 310, 552, 572) est plane et est d'une seule pièce avec la languette (18, 42, 44, 118, 218, 318, 418, 518, 558, 559, 574).

3. Conducteur portant de la soudure selon la revendication 1 ou 2 dans lequel la portion de corps (16, 110, 210, 310, 416) possède sur au moins un bord une paire de languettes (18, 42, 44, 118, 218, 318, 418, 518) s'étendant latéralement et définissant entre elles une ouverture (20)

4. Conducteur selon la revendication 3, dans lequel ladite ouverture (20) et ladite portion de corps forment un canal destiné à recevoir ladite masse de soudure.

5. Conducteur portant de la soudure selon l'une quelconque des revendications 1 à 4, caractérisé en ce que cette portion de corps (16, 110, 210, 310) possède sur chaque bord une paire de languettes espacées l'une de l'autre (18, 42, 44, 118, 218, 318) formant entre elles une ouverture, ladite ouverture étant alignée transversalement à ce corps pour former un canal (24, 48, 320, 322).

6. Conducteur portant de la soudure selon la revendication 1 ou 2, dans lequel la portion de corps (552, 572) et l'extrémité de cette plaque (559, 574) s'étendent pratiquement toutes deux dans la direction de cette portion de corps.

7. Conducteur portant de la soudure selon l'une quelconque des revendications 1 à 6, dans lequel chacune des languettes (18, 42, 44, 118, 218, 318, 418, 518, 558, 559, 574) est recourbée le long de cette portion de corps (16, 110, 210, 310, 416, 552, 572) pour retenir ladite masse de soudure (26, 44', 226, 326, 426, 526, 564).

8. Conducteur portant de la soudure selon l'une quelconque des revendications 4 à 7, dans lequel lesdites languettes (18, 42, 44, 118, 218, 318, 418, 518, 558, 559, 574) sont recourbées vers l'intérieur dudit canal (24, 48, 320, 322, 566) et sont piquées dans la masse de soudure.

9. Conducteur portant de la soudure selon l'une quelconque des revendications 1, 2 ou 6, dans lequel lesdites languettes (558, 559, 574) sont au nombre de deux, chacune ayant la forme d'un doigt, l'une de chaque bordure de cette portion de corps plane (552, 572) et lesdits doigts en forme de languette s'incurvant le long de ladite portion de corps.

10. Conducteur portant de la soudure selon la revendication 9, destiné au soudage de surface sur une surface conductrice, dans lequel chaque doigt de languette (558, 559, 574) et l'une des extrémités de la portion de corps forment entre eux un canal (566).

11. Conducteur portant de la soudure selon la revendication 9 ou 10, les extrémités de ces doigts de languettes (558, 559, 574) encerclant partiellement lesdits moyens de soudure (564).

12. Conducteur portant de la soudure selon l'une quelconque des revendications 9 à 11, dans lequel les extrémités desdits doigts de languettes (558, 559, 574) sont piquées dans la masse de soudure (564).

13. Conducteur portant de la soudure selon l'une quelconque des revendications 1 à 12, dans lequel ladite masse de soudure (26, 44', 226, 326, 426, 526, 564) est supportée par lesdites languettes (18, 42, 44, 118, 218, 318, 418, 518, 558, 559, 574) transversalement à au moins une des arêtes de cette portion de corps (16, 110, 210, 310, 416, 552, 572) d'où s'étendent ces languettes.

14. Conducteur portant de la soudure selon l'une quelconque des revendications 1 à 13, dans lequel ladite masse de soudure (26, 44', 226, 326, 426, 526, 564) s'étend au delà de ladite au moins une extrémité de cette portion de corps (16, 110, 210, 310, 416, 552, 572) d'où s'étend ladite au moins une languette (18, 42, 44, 118, 218, 318, 418, 518, 558, 559, 574).

**15.** Conducteur portant de la soudure selon l'une quelconque des revendications 1 à 14, dans lequel ladite masse de soudure (26, 44', 226, 326, 426, 526, 564) s'étend vers l'extérieur à partir de ce canal (24, 48, 320, 322, 566).

**16.** Conducteur portant de la soudure selon l'une quelconque des revendications 1 à 14, dans lequel la dimension de cette masse de soudure est pratiquement égale au dépassement de cette languette (18, 42, 44, 118, 218, 318, 418, 518, 558, 559, 574) par rapport à ladite portion de corps.

**17.** Conducteur portant de la soudure selon l'une quelconque des revendications 1 à 16, dans lequel une des extrémités dudit conducteur (10, 50, 60, 110, 511, 550) est constituée d'un élément électrique.

**18.** Conducteur portant de la soudure selon l'une quelconque des revendications 1 à 17, dans lequel ledit conducteur comprend une broche de plaquette de circuit imprimé.

**19.** Conducteur portant de la soudure selon l'une quelconque des revendications 1 à 17, dans lequel ledit conducteur comprend un contact de connexion recevant une broche.

**20.** Conducteur portant de la soudure selon l'une quelconque des revendications 1 à 17, ledit conducteur comprend un contact de connecteur de plaquette de circuit imprimé.

**21.** Conducteur portant de la soudure selon l'une des revendications 1 à 20, comprenant en outre un doigt formant ressort (22, 52, 322, 510) faisant partie intégrante de cette portion de corps de conducteur (16, 110, 210, 310, 552, 572) et étant placé à l'opposé de ladite masse de soudure (26, 44', 226, 326, 426, 526, 564) pour former un dispositif de broche pour une plaquette de circuit imprimé ou analogue.

**22.** Procédé de formation d'un conducteur portant de la soudure (10, 50, 60, 511, 550) pouvant être soudé à une surface conductrice (36, 41, 56, 66, 229, 578), caractérisé par les étapes suivantes:
- formation d'un flanc allongé analogue à une bande avec une portion de corps (16, 110, 210, 310, 416, 552, 572), ce flanc comportant au moins une paire de languettes (18, 42, 44, 118, 218, 318, 418, 518, 558, 559, 574), lesdites languettes s'étendant latéralement depuis ladite portion de corps, au moins une des languettes de chaque paire étant placée sur un des bords de celle-ci,
- courbure de chacune de ces languettes sur le bord de ladite portion de corps de façon pratiquement perpendiculaire à cette dernière,
- mise en place d'une masse de soudure (26, 44',226, 326, 426, 526) sur cette portion de corps, et
- piquage des arêtes de cette paire de languettes le long de ladite portion de corps et dans la masse de soudure pour fixer cette dernière à cette portion de corps.

**23.** Procédé selon la revendication 22, comprenant l'étape de formation d'une paire de languettes espacées (18, 42, 44, 118, 218, 318, 418, 518) avec une ouverture entre elles le long d'un des bords de ce flanc.

**24.** Procédé selon la revendication 23, comprenant en outre, les étapes de formation sur un autre bord dudit flanc d'une seconde paire de languettes espacées l'une de l'autre (18, 42, 44, 118, 218, 318, 518) s'étendant latéralement, avec une seconde ouverture alignée avec ladite première ouverture transversalement à la portion de corps (16, 110, 210, 310),
- courbure de ladite seconde paire de languettes de façon pratiquement perpendiculaire à ladite portion de corps pour former un canal (24, 48, 320, 322) possédant des côtés formés par ces deux paires de languettes espacées les unes des autres, et un fond formé par cette portion de corps,
- mise en place de ladite masse de soudure (26, 44', 226, 326, 526) dans ce canal, et piquage des arêtes de ladite seconde paire de languettes le long de cette portion de corps avec la masse de soudure.

**25.** Procédé selon la revendication 24, dans lequel ladite masse de soudure (26, 44', 226, 326, 526) s'étend vers l'extérieur de ce canal (24, 48, 320, 322) au delà des extrémités desdites languettes (18, 42, 44, 118, 218, 318, 518).

**26.** Procédé selon l'une quelconque des revendications 22 à 25, dans lequel ladite masse de soudure (26, 44' 226, 326, 526) s'étend dans l'ouverture entre ces languettes (18, 42, 44, 118, 218, 318, 518) sur chaque bord de ladite portion de corps (16, 110, 210, 310).

**27.** Procédé sel on l'une des revendications 22 à 24, dans lequel ladite masse de soudure (26, 449, 226, 326, 426, 526) se trouve pratiquement au niveau desdites extrémités de ces languettes (18, 42, 44, 118, 218, 318, 418, 518).

28. Procédé selon l'une quelconque des revendications 22 à 24, ladite masse de soudure (26, 44', 226, 326, 426, 526, 564) est compressée au-dessous de l'extrémité desdites languettes (18, 42, 44, 118, 218, 318, 418, 518, 559, 574).

29. Borne pour un conducteur pour le montage en surface sur un substrat possédant une zone conductrice (36, 41, 56, 66, 229, 578) comprenant un conducteur muni d'une masse de soudure, selon l'une quelconque des revendications 1 à 21, dans lequel lesdites languettes (18, 42, 118, 218, 318, 418, 518, 559, 574) sont placées au voisinage d'une des extrémités de dudit conducteur (10, 50, 60, 511, 550).

**Patentansprüche**

1. Lottragender Leiter (10, 50, 60, 511, 550) zum Anlöten an eine leitende Oberfläche (36, 41, 56, 66, 229, 578), mit einem langgestreckten Körperbereich (16, 110, 210, 310, 416, 552, 572) der eine Einrichtung (18, 42, 44, 118, 218, 318, 418, 518, 558, 559, 574) zum Aufnehmen einer Lötmasse (26, 44', 226, 326, 426, 526, 564) am Körperbereich aufweist, **gekennzeichnet durch** einen streifenförmigen Körperbereich (16, 110, 210, 310, 416, 552, 572), der an wenigstens einer seiner Kanten mindestens eine sich seitwärts erstreckende Lasche (18, 42, 44, 118, 218, 318, 418, 518, 558, 559, 574) aufweist, wobei jede Lasche in einer Ebene gebogen ist, die sich im wesentlichen senkrecht zur Ebene des Körperbereichs erstreckt, um die Lötmasse im wesentlichen quer zum Körperbereich zu halten.

2. Lottragender Leiter nach Anspruch 1, wobei der Körperbereich (16, 110, 210, 310, 552, 572) plan und einstückig mit der Lasche (18, 42, 44, 118, 218, 318, 418, 518, 558, 559, 574) ist.

3. Lottragender Leiter nach Anspruch 1 oder 2, wobei der Körperbereich (16, 110, 210, 310, 416) an wenigstens einer seiner Kanten ein Paar beabstandeter, sich seitlich erstreckender Laschen (18, 42, 44, 118, 218, 318, 418, 518) aufweist, die zwischen sich eine Öffnung (20) bilden.

4. Leiter nach Anspruch 3, wobei die Öffnung (20) und der Körperbereich einen Kanal bilden, um die Lötmasse aufzunehmen.

5. Lottragender Leiter nach einem der Ansprüche 1 bis 4, **dadurch gekennzeichnet,** daß der Körperbereich (16, 110, 210, 310) an jeder Kante ein Paar beabstandeter Laschen (18, 42, 44, 118, 218, 318) mit einer dazwischen ausgebildeten Öffnung aufweist, wobei die Öffnung quer zum Körper ausgerichtet ist, um einen Kanal (24, 48, 320, 322) zu bilden.

6. Lottragender Leiter nach Anspruch 1 oder Anspruch 2, wobei der Körperbereich (552, 572) und das Ende der Lasche (559, 574) sich im wesentlichen gemeinsam in Richtung des Körperbereichs erstrecken.

7. Lottragender Leiter nach einem der Ansprüche 1 bis 6, wobei jede der Laschen (18, 42, 44, 118, 218, 318, 418, 518, 558, 559, 574) in Längsrichtung des Körperbereichs (16, 110, 210, 310, 416, 552, 572) zum Zurückhalten der Lötmasse (26, 44', 226, 326, 426, 526, 564) gebogen ist.

8. Lottragender Leiter nach einem der Ansprüche 4 bis 7, wobei die Laschen (18, 42, 44, 118, 218, 318, 418, 518, 558, 559, 574) in den Kanal (24, 48, 320, 322, 566) gebogen und in die Lötmasse eingedrückt sind.

9. Lottragender Leiter nach einem der Ansprüche 1, 2 oder 6, wobei die Laschen (558, 559, 574) in zwei Exemplaren vorliegen, jede in der Form eines Fingers, wobei jeweils eine an jeder Kante des ebenen Körperbereichs (552, 572) vorgesehen ist, und daß sich die Laschenfinger in Längsrichtung entlang des Körperbereichs krümmen.

10. Lottragender Leiter nach Anspruch 9 zum Oberflächenlöten auf eine leitende Oberfläche, wobei jeder der Laschenfinger (558, 559, 574) und ein Ende des Körperbereichs einen dazwischenliegenden Kanal (566) bilden.

11. Lottragender Leiter nach Anspruch 9 oder 10, wobei die Enden der Laschenfinger (558, 559, 574) teilweise die Lötmasse (564) umschließen.

12. Lottragender Leiter nach einem der Ansprüche 9 bis 11, wobei die Enden der Laschenfinger (558, 559, 574) in die Lötmasse (564) eingedrückt sind.

13. Lottragender Leiter nach einem der Ansprüche 1 bis 12, wobei die Lötmasse (26, 44', 226, 326, 426, 526, 564) durch die Laschen (18, 42, 44, 118, 218, 318, 418, 518, 558, 559, 574) quer zu der mindestens einen Kante des Körperbereichs (16, 110, 210, 310, 416, 552, 572), von der sich die Laschen erstrecken, gehalten ist.

14. Lottragender Leiter nach einem der Ansprüche 1 bis 13, wobei die Lötmasse (26, 44', 226, 326, 426, 526, 564) bis über die mindestens eine Kante des Körperbereichs (16, 110, 210, 310, 416, 552, 572), von der sich die mindestens eine Lasche (18, 42, 44, 118, 218, 318, 418, 518, 558, 559, 574) erstreckt, vorsteht.

15. Lottragender Leiter nach einem der Ansprüche 1 bis 14, wobei sich die Lötmasse (26, 44', 226, 326, 426, 526, 564) aus dem Kanal (24, 48, 320, 322, 566) hinauserstreckt.

16. Lottragender Leiter nach einem der Ansprüche 1 bis 14, wobei die Abmessung der Lötmasse im wesentlichen gleich der Erstreckung der Laschen (18, 42, 44, 118, 218, 318, 418, 518, 558, 559, 574) vom Körperbereich weg ist.

17. Lottragender Leiter nach einem der Ansprüche 1 bis 16, wobei ein Ende des Leiters (10, 50, 60, 110, 511, 550) als ein elektrisches Element ausgebildet ist.

18. Lottragender Leiter nach einem der Ansprüche 1 bis 17, wobei der Leiter einen Leiterplattenklemme enthält.

19. Lottragender Leiter nach einem der Ansprüche 1 bis 17, wobei der Leiter einen einen Stift aufnehmenden Verbindungskontakt enthält.

20. Lottragender Leiter nach einem der Ansprüche 1 bis 17, wobei der Leiter einen Leiterplatten-Verbindungskontakt aufweist.

21. Lottragender Leiter nach einem der Ansprüche 1 bis 20, der weiterhin einen einstückig mit dem Körperbereich (16, 110, 210, 310, 552, 572) des Leiters ausgebildeten und gegenüber der Lötmasse (26, 44', 226, 326, 426, 526, 564) angeordneten Federfinger (22, 52, 322, 510) aufweist, um eine Klemmenanordnung für eine Leiterplatte oder dgl. zu bilden.

22. Verfahren zum Bilden eines lottragenden Leiters (10, 50, 60, 511, 550) zum Anlöten an eine leitende Oberfläche (26, 41, 56, 66, 229, 578), **gekennzeichnet durch** die Verfahrensschritte des Herstellens eines flachen, langgestreckten, streifenförmigen Rohlings mit einem Körperbereich (16, 110, 210, 310, 416, 552, 572), wobei der Rohling mindestens ein Paar von Laschen (18, 42, 44, 118, 218, 318, 418, 518, 558, 559, 574) aufweist, wobei die Laschen sich vom Körperbereich seitwärts erstrecken, und wobei mindestens eine Lasche jedes Paars an einer seiner Kanten angeordnet ist, des Biegens jeder der Laschen an der Kante des Körperbereichs im wesentlichen rechtwinklig zum Körperbereich, des Anordnens einer Lötmasse (26, 44, 226, 326, 426, 526) am Körperbereich, und des Eindrückens der Kanten des Paars der Laschen in Längsrichtung zum Körperbereich und in die Lötmasse, um die Lötmasse am Körperbereich zu befestigen.

23. Verfahren nach Anspruch 22, enthaltend den Verfahrensschritt des Ausbildens eines Paars von beabstandeten Laschen (18, 42, 44, 118, 218, 318, 418, 518) die mit einer dazwischenliegenden Öffnung (20) entlang einer Kante des Rohlings versehen sind.

24. Verfahren nach Anspruch 23, weiterhin enthaltend die Verfahrensschritte des Ausbildens eines zweiten Paars von sich seitwärts erstreckenden, beabstandeten Laschen (18, 42, 44, 118, 218, 318, 518) an einer weiteren Kante des Rohlings, mit einer zweiten, mit der erstgenannten Öffnung quer über den Körperbereich (16, 110, 210, 310) ausgerichteten Öffnung, des Biegens des zweiten Paars der Laschen im wesentlichen senkrecht zum Körperbereich, um einen Kanal (24, 48, 320, 322) zu bilden, der durch die beiden Paare beabstandeter Laschen gebildete Seiten und einen durch den Körperbereich gebildeten Boden aufweist, des Anordnens der Lötmasse (26, 44', 226, 326, 526) im Kanal, und des Eindrückens der Ecken des zweiten Paars der Laschen in Längsrichtung zum Körperbereich zusammen mit der Lötmasse.

25. Verfahren nach Anspruch 24, wobei die Lötmasse (26, 44', 226, 326, 526) sich über die Spitzen der Laschen (18, 42, 44, 118, 218, 318, 518) aus dem Kanal (24, 48, 320, 322) hinauserstreckt.

26. Verfahren nach einem der Ansprüche 22 bis 25, wobei sich die Lötmasse (26, 44', 226, 326, 526) in die Öffnung zwischen den Laschen (18, 42, 44, 118, 218, 318, 518) an jeder Kante des Körperbereichs (16, 110, 210, 310) hineinerstreckt.

27. Verfahren nach einem der Ansprüche 22 bis 24, wobei die Lötmasse (26, 44', 226, 326, 426, 526) sich im wesentlichen auf dem gleichen Niveau mit den Spitzen der Laschen (18, 42, 44, 118, 218, 318, 418, 518) befindet.

28. Verfahren nach einem der Ansprüche 22 bis 24, wobei die Lötmasse (26, 44', 226, 326, 426, 526, 564) unter die Spitzen der Laschen (18, 42, 44, 118, 218, 318, 418, 518, 558, 559, 574) eingedrückt ist.

29. Klemme für einen Leiter zur Oberflächenbefestigung auf einem Substrat mit einer leitenden Fläche (36, 41, 56, 66, 229, 578), die einen lottragenden Leiter nach einem der Ansprüche 1 bis 29 aufweist, wobei die Laschen (18, 42, 118, 218, 318, 418, 518, 558, 559, 574) in der Nähe eines Endes des Leiters (10, 50, 60, 511, 550) angeordnet sind.

FIG. 1

FIG. 2

FIG. 3

FIG. 4

FIG. 5

FIG. 4A

FIG. 6

13

# FIG. 7

# FIG. 8

# FIG. 9

# FIG. 10

# FIG. 11

# FIG. 12

## FIG. 13

## FIG. 14

## FIG. 15

# FIG. 16

# FIG. 17

# FIG. 18

FIG. 19

FIG. 20

FIG. 21

FIG. 22